# EUROPÄISCHE PATENTANMELDUNG

(11) **EP 4 435 661 A1**
(43) Veröffentlichungstag der Anmeldung: **25.09.2024**
(21) Anmeldenummer: 23163168.0
(22) Anmeldetag: 21.03.2023
(51) Int. Cl.: G06F 30/27

(54) **PERSONENSTROMSIMULATION MIT MAKROSKOPISCHEM UND MIKROSKOPISCHEM SIMULATIONSVERFAHREN**

(71) Anmelder: Siemens Aktiengesellschaft, 80333 München (DE)
(72) Erfinder: Mayer, Hermann Georg, 83209 Prien am Chiemsee (DE)
(74) Vertreter: Siemens Patent Attorneys

(57) **Zusammenfassung**

Die Erfindung betrifft ein Verfahren zur Simulation von Personenströmen in einem mehrere Teilgebiete umfassenden Gebiet, bei dem für ein erstes Teilgebiet eine makroskopische Personenstromsimulation berechnet wird. Bei der makroskopischen Simulation werden als Eingangsdaten zumindest eine Personenanzahl an zumindest einer Eingangsschnittstelle (ENTER) des ersten Teilgebiets verwendet, und als Ergebnis wird zumindest eine Personenanzahl an zumindest einer Ausgangsschnittstelle (EXIT) des ersten Teilgebiets berechnet. Für ein zweites Teilgebiet (MIKRO 1, MIKRO 2) wird eine mikroskopische Personenstromsimulation berechne. Bei der mikroskopischen Simulation werden als Eingangsdaten die zumindest eine berechnete Personenanzahl an der zumindest einen Ausgangsschnittstelle (EXIT) des ersten Teilgebiets verwendet, und als Ergebnis wird eine Verteilung von Personen innerhalb des zweiten Teilgebietes (MIKRO 1, MIKRO 2) für mehrere Zeitpunkte berechnet. Weiterhin betrifft die Erfindung hierzu korrespondierend eine Vorrichtung oder ein System zur Datenverarbeitung, ein Computerprogramm, einen computerlesbaren Datenträger, sowie ein Übertragungssignal.

## Beschreibung

Die Erfindung betrifft ein Verfahren zur Simulation von Personenströmen in einem mehrere Teilgebiete umfassenden Gebiet.

Eine Personenstromsimulation ist eine Computersimulation, bei der die Bewegungen von Personen auf der Grundlage eines mathematischen Modells simuliert werden. Vereinfacht ausgedrückt imitieren Personenstromsimulationen das Verhalten einer großen Anzahl von Menschen im räumlichen Gebieten. Hierzu berechnet die Simulation die zeitlich und räumlich gesehen nächste Position einer Person anhand von bestimmten Vorschriften oder maschinengelerntem Vorgehen, wodurch ein menschliches Verhaltensmuster nachgeahmt werden soll. Hierzu können verschiedene Modelle aus dem Bereich der Mikro- bzw. Makromodellierung zum Einsatz kommen. Der Einsatzzweck dieser Simulationen ist vielfältig, ein prominentes Beispiel ist die Berechnung von Evakuierungssituationen.

Ein besonders interessanter Einsatz von Personenstromsimulationen sind Echtzeitanwendungen. Hierbei soll das Ergebnis der Simulation ermöglichen, die Personenströme im betrachteten Gebiet zu lenken, womit z.B. ungünstige von der Simulation prognostizierte Szenarien verhindert oder abgemildert werden können. Echtzeit impliziert, dass während einem realen Geschehen durch die Simulation vom aktuellen Zeitpunkt aus in der Zukunft liegende Zustände vorhergesagt werden, so dass diese zukünftigen Zustände durch geeignete Eingriffe beeinflusst werden können.

Der Erfindung liegt die Aufgabe zugrunde, ein Verfahren zur Simulation von Personenströmen in einem Gebiet aufzuzeigen, welches sich insbesondere für Echtzeitanwendungen eignet.

Diese Aufgabe wird durch ein Verfahren mit den Merkmalen des Anspruchs 1 gelöst. Ferner sind Gegenstand der Erfindung eine entsprechende Vorrichtung oder ein System zur Datenverarbeitung, ein entsprechendes Computerprogramm, ein entsprechendes computerlesbares, vorzugsweise nichtflüchtiges, Speichermedium, und ein entsprechendes Übertragungssignal. Vorteilhafte Ausgestaltungen und Weiterbildungen sind Gegenstand von Unteransprüchen.

Das Verfahren zur Simulation von Personenströmen betrifft ein mehrere Teilgebiete umfassendes Gebiet. Für ein erstes dieser Teilgebiete wird eine makroskopische Personenstromsimulation berechnet. Für die makroskopische Simulation werden als Eingangsdaten zumindest eine Personenanzahl an zumindest einer Eingangsschnittstelle des ersten Teilgebiets verwendet. Als Ergebnis der makroskopischen Simulation wird zumindest eine Personenanzahl an zumindest einer Ausgangsschnittstelle des ersten Teilgebiets berechnet. Für ein zweites der Teilgebiete wird eine mikroskopische Personenstromsimulation berechnet. Für die mikroskopische Simulation werden als Eingangsdaten die zumindest eine berechnete Personenanzahl an der zumindest einen Ausgangsschnittstelle des ersten Teilgebiets verwendet. Als Ergebnis der mikroskopischen Simulation wird eine Verteilung von Personen innerhalb des zweiten Teilgebietes für mehrere Zeitpunkte berechnet.

Das betrachtete Gebiet kann aus dem ersten und dem zweiten Teilgebiet bestehen. Alternativ kann es weitere Teilgebiete umfassen, für welche eine makroskopische oder mikroskopische Simulation stattfindet. Das erste und das zweite Teilgebiet sind vorzugsweise benachbart, so dass eine Person von dem ersten direkt in das zweite Teilgebiet gelangen kann.

Für die makroskopische Simulation wird bei dem ersten Teilgebiet zumindest eine Eingangsschnittstelle und zumindest eine Ausgangsschnittstelle betrachtet. Über diese Schnittstellen können Personen in das erste Teilgebiet gelangen bzw. dieses verlassen, sie entsprechen also Ein- bzw. Ausgängen des ersten Teilgebiets. Die konkrete Ausgestaltung dieser Schnittstellen kann unterschiedlich sein, z.B. kann es sich um Türen, Pforten, Drehkreuze oder auch bestimmte Bestandteile von Wegen handeln. Es kann eine Mehrzahl von Eingangsschnittstellen und/oder eine Mehrzahl von Ausgangsschnittstellen verwendet werden. Vorzugsweise existieren außer den bei der makroskopischen Simulation verwendeten Ein- und Ausgangsschnittstellen keine weiteren Schnittstellen, über welche Personen in das erste Teilgebiet gelangen bzw. dieses verlassen können.

Bei der makroskopischen Simulation sind Details innerhalb des simulierten ersten Teilgebiets nicht relevant. Hier spielen vielmehr Personenanzahlen eine Rolle, und zwar an der oder den Eingangsschnittstellen, sowie an der oder den Ausgangsschnittstellen. Zumindest eine Personenanzahl an zumindest einer Eingangsschnittstelle wird dementsprechend der Berechnung der makroskopischen Simulation zugrunde gelegt, und zumindest eine Personenanzahl an zumindest einer Ausgangsschnittstelle ist das Ergebnis der makroskopischen Simulation.

Im Gegensatz zur makroskopischen Simulation ist bei der mikroskopischen Simulation, welche für das zweite Teilgebiet durchgeführt wird, die Situation innerhalb dieses Teilgebiets von Interesse. Durch die mikroskopische Simulation soll der Zeitverlauf einer Personenverteilung im zweiten Teilgebiet bestimmt werden. Dies sind diejenigen Prognosewerte, welche einer Echtzeitanwendung zugrunde gelegt werden können, um Personenströme steuernd in das zweite Teilgebiet einzugreifen. Die mikroskopische Simulation fußt auf dem Ergebnis der makroskopischen Simulation, d.h. die durch die makroskopische Simulation berechnete Personenanzahl an der zumindest einen Ausgangsschnittstelle wird als Eingangsdaten der mikroskopischen Simulation zugrunde gelegt.

Die zumindest eine Personenanzahl an der zumindest einen Eingangsschnittstelle und die zumindest eine Personenanzahl an der zumindest einen Ausgangsschnittstelle des ersten Teilgebiets kann eine Zeitreihe von Personenflüssen sein, oder eine Zeitreihe von akkumulierten Personenanzahlen. Es werden in diesem Fall als Eingangs- und Ergebnisdaten der makroskopischen Simulation also nicht ein einzelner Wert einer Personenanzahl verwendet, sondern vielmehr eine Reihe von Werten, welche verschiedene Zeitunkte betreffen. Diese können als Personenflüsse zum Einsatz kommen, also als Personenanzahl pro Zeiteinheit, oder als akkumulierte Anzahlen, also als bis zu einem bestimmten Zeitpunkt summierte Personenanzahlen.

Vorteilhaft ist es, wenn die makroskopische Personenstromsimulation unter Verwendung einer künstlichen Intelligenz berechnet wird. Hierfür können an sich bekannte KI Systeme zum Einsatz kommen. Der Einsatz einer künstlichen Intelligenz ist einerseits deshalb vorteilhaft, weil dies eine rasche Berechnung des Ergebnisses ermöglicht, auf welches die mikroskopische Simulation dann aufbauen kann, und andererseits, weil diese üblicherweise komplexe Zusammenhänge zwischen Eingangs- und Ausgangsdaten erlernen kann.

Die künstliche Intelligenz wird vor Berechnung der makroskopische Personenstromsimulation unter Verwendung von Trainingsdaten trainiert. Hierbei können die Trainingsdaten zumindest eine Personenanzahl an der zumindest einen Eingangsschnittstelle des ersten Teilgebiets und zumindest eine Personenanzahl an der zumindest einen Ausgangsschnittstelle des ersten Teilgebiets umfassen. Die Trainingsdaten beinhalten also Zusammenhänge zwischen Daten der Art, wie sie später von der künstlichen Intelligenz als Eingangsdaten verarbeitet werden, und der Art, wie sie später von der künstlichen Intelligenz als Ergebnis ausgegeben werden.

Vorteilhaft ist es, wenn die Trainingsdaten mittels einer mikroskopischen Personenstromsimulation des ersten Teilgebiets generiert werden. Hierbei können an sich bekannte Techniken der mikroskopischen Simulation zum Einsatz kommen. Für die mikroskopische Simulation wird u.a. ein Modell der Topologie des ersten Teilgebiets herangezogen. Der mikroskopischen Simulation wird zumindest eine Personenanzahl an der zumindest einen Eingangsschnittstelle des ersten Teilgebiets vorgegeben, woraus zumindest eine Personenanzahl an der zumindest einen Ausgangsschnittstelle des ersten Teilgebiets berechnet werden kann. Zur Generierung der Trainingsdaten kann eine Vielzahl von mikroskopischen Personenstromsimulation des ersten Teilgebiets mit verschiedenen Personenanzahlen an der zumindest einen Eingangsschnittstelle des ersten Teilgebiets berechnet werden. Je mehr Trainingsdaten mittels mikroskopischer Personenstromsimulation berechnet und der künstlichen Intelligenz zur Verfügung gestellt werden, desto besser fällt im Schnitt das Ergebnis der makroskopischen Simulation des gleichen Teilgebietes durch die künstliche Intelligenz aus.

Alternativ zur Generierung der Trainingsdaten mittels mikroskopischer Personenstromsimulation können diese auch über Messungen von Personenanzahlen im ersten Teilgebiet ermittelt werden. In diesem Fall werden Personenanzahlen an der zumindest einen Eingangsschnittstelle und der zumindest einen Ausgangsschnittstelle durch geeignete Sensorik erfasst.

Die Eingangsdaten für die makroskopische Personenstromsimulation des ersten Teilgebiets können mittels Messungen von Personenanzahlen im ersten Teilgebiet ermittelt werden. Im tatsächlichen Einsatz der Personenstromsimulation erfolgt also zuerst eine Messung an der zumindest einen Eingangsschnittstelle, dann eine makroskopische Simulation unter Verwendung der Messergebnisse, dann eine mikroskopische Simulation unter Verwendung der Ergebnisse der makroskopischen Simulation.

Bei der künstlichen Intelligenz kann es sich um ein LSTM-Netz handeln, welchem zur Berechnung der makroskopischen Personenstromsimulation die Eingangsdaten als Zeitverlauf variabler Länge zur Verfügung gestellt werden. Ein solches Long Short-Term Memory Netz eignet sich besonders für das Erlernen von Zusammenhängen zwischen verschiedenen Zeitverläufen. Alternativ hierzu kann es sich bei der künstlichen Intelligenz um ein neuronales Netz handeln, welchem zur Berechnung der makroskopische Personenstromsimulation die Eingangsdaten als Vektor konstanter Länge zur Verfügung gestellt werden. Hierbei kann ausgenutzt werden, dass bei vielen für die Simulation relevanten Szenarien nur ein begrenzter Zeitraum existiert, innerhalb welchem sich die Personenanzahlen verändern, wie z.B. nach Ende eines Großereignisses. Aus diesen Daten aus dem begrenzten Zeitraum kann ein Vektor einer bestimmten Länge gebildet werden.

Das erfindungsgemäße Verfahren und/oder eine oder mehrere Funktionen, Merkmale und/oder Schritte des erfindungsgemäßen Verfahrens und/oder einer seiner Ausgestaltungen können computergestützt ablaufen. Es kann beispielsweise mittels eines oder mehrerer Computer, Prozessoren, anwendungsspezifischer integrierter Schaltungen (ASIC), digitaler Signalprozessoren (DSP) und/oder sogenannter "Field Programmable Gate Arrays" (FPGA) ausgeführt bzw. implementiert werden. Es kann auch zumindest teilweise in einer Cloud und/oder in einer Edge-Computing-Umgebung ausgeführt werden. Für den computergestützten Ablauf kommt eines oder mehrere miteinander zusammenwirkende Computerprogramme zum Einsatz. Werden mehrere Programme verwendet, so können diese gemeinsam auf einem Computer gespeichert und von diesem ausgeführt werden, oder auch auf verschiedenen Computern an verschiedenen Orten. Da dies funktional gleichbedeutend ist, wird vorliegend im Singular "das Computergrogramm" und "der Computer" formuliert.

Im Folgenden wird die Erfindung anhand eines Ausführungsbeispiels näher erläutert. Dabei zeigen:
- Figur 1:: ein für eine Personenstromsimulation betrachtetes Gebiet,
- Figur 2:: einen Satz von Trainingsdaten,
- Figur 3:: das Lernen eines neuronalen Netzes,
- Figur 4:: ein Ablaufdiagramm,
- Figur 5:: ein System zur computergestützten Verfahrensdurchführung,
- Figur 6:: eine detailliertere Darstellung eines Systems gemäß Figur 5.

Ein Personenstromsimulationsmodell modelliert die Bewegungen von Menschen in räumlichen Umgebungen. Typische hierbei betrachtete Gebiete sind z.B. Bahnhöfe, Flughäfen, Sportstadien. Durch Ablaufenlassen der Simulation können verschiedene Szenarien betrachtet werden, wie z.B. Evakuierungen von Bürogebäuden oder Hotels im Brandfall, das zeitgleiche Eintreffen einer Vielzahl von Personen in einem begrenzten Gebiet wie z.B. zu Beginn oder Ende eines Sportereignisses in einem Stadion, oder auch die Auswirkungen von Designänderungen innerhalb von Gebäuden oder öffentlichen Räumen auf Aspekte wie Sicherheit oder Effizienz des Personenverkehrs.

Interessant ist dabei insbesondere eine mikroskopische Simulation. Derartige Simulationen bilden die Bewegung einzelner Personen ab. Die Simulation startet hierbei in einem Zustand, in welchem eine bestimmte Anzahl von Personen sich an bestimmten Startorten innerhalb des betrachteten Gebietes befinden und von dort aus ihre Bewegung beginnen, oder auch eine bestimmte Verteilung von Personen innerhalb des Gebietes vorliegt. Hierbei können die Startorte eines oder mehrere Bereiche innerhalb des Gebietes sein, wie z.B. Ein- oder Ausgänge. Dem Personenstromsimulationsmodell werden personenbezogene Parameter vorgegeben, welche die Bewegung einzelner Personen bestimmen. Bei diesen Parametern kann es sich um die angestrebte Geschwindigkeit handeln, sowie um bevorzugte und minimale Abstände zu anderen Personen. Ferner werden einer oder mehrere Zielorte vorgegeben, welche die Personen erreichen möchten. Das Ergebnis der mikroskopischen Personenstromsimulation ist der zeitliche Verlauf der Verteilung der Personen in dem betrachteten Gebiet; d.h. für die in der Zukunft nach dem Start der Simulation liegenden Zeitpunkte prognostiziert das Personenstromsimulationsmodell, an welchen Orten innerhalb des Gebietes sich eine Person befindet.

Ein Nachteil dieser Technologie der mikroskopischen Simulation ist der hohe Zeitaufwand, der mit der Berechnung der Simulationsergebnisse verbunden ist. So dauert z.B. die Simulation einer Evakuierung eines Fußballstadions mit 60.000 Personen derzeit auf einem durchschnittlichen Notebook eine bis mehrere Stunden. Die fortschreitende Computer- und Cloud-Technik wird die Performance zwar zukünftig verbessern; so kann man bislang durch den Einsatz schnellerer Rechner oder durch Nutzung von Rechenleistung in der Cloud die o.g. Probleme teilweise kompensieren, z.B. durch zahlreiche parallele Berechnung von Statistik-Läufen. Von Echtzeitanwendungen, z.B. für Einsatzleitsysteme, ist man aber immer noch weit entfernt. Von einer solchen Echtzeitanwendungen erwartet man, dass "auf Knopfdruck", d.h. annähernd instantan nach Start der Simulation, das Ergebnis der Simulation zur Verfügung steht, so dass hierauf reagiert werden kann.

Die Performance einer mikroskopischen Personenstromsimulation, also wie schnell das Simulationsergebnis zur Verfügung steht, hängt im Wesentlichen von der Größe des Gebiets und der Komplexität der darin befindlichen Hindernisse ab, sowie auch von der Anzahl der Personen, die sich im betrachteten Gebiet befinden. Die Performance spielt einerseits dann eine Rolle, wenn zu Zwecken statistischer Signifikanz viele Simulationsläufe von großen Szenarien durchgeführt werden sollen. Insbesondere aber bei Echtzeitanforderungen für Simulation@Operation Applikationen spielt es zunehmend eine Rolle, rechtzeitig auf Ergebnisse reagieren zu können, die von der Simulation geliefert werden. Die Akzeptanz solcher Applikationen ist umso besser, je kürzer die Wartezeit auf das Simulationsergebnis ist. Als harte obere Grenze gilt natürlich, dass die Simulation schneller sein muss als die echte vergangene Zeit, da sonst der von der Simulation als Ergebnis gelieferte Zeitpunkt bereits eingetreten oder sogar vergangen ist, so dass man nicht mehr geeignet reagieren kann, z.B. im Rahmen eines Einsatzleitsystems.

Wie erläutert ist ein bedeutender Faktor hinsichtlich des Ressourcenbedarfs einer Personenstromsimulation die mikroskopische Simulation, d.h. das Simulieren der Bewegung einzelner Personen mit detaillierten Hindernissen. Wesentlich schneller können Personenstromsimulationen mit makroskopischen Ansätzen durchgeführt werden. Bei einem solchen flussbasierten Ansatz wird nur ein bestimmter Personenfluss, also eine Anzahl von Personen pro Zeiteinheit, betrachtet, der an Übergängen zwischen verschiedenen Teilgebieten vorliegt. Die Verteilung von Personen innerhalb eines Teilgebiets ist - im Gegensatz zur mikroskopischen Simulation - nicht relevant. Der Nachteil bei einer makroskopischen Simulation ist dementsprechend, dass sich bestimmte Effekte nicht darstellen lassen, wie z.B. wie weit ein Personenstau in einen Gang zurückreicht oder ein Abbremsverhalten durch gegenläufige Personenströme.

Im Folgenden wird ein Ansatz vorgestellt, welcher die Vorteile beider Verfahren, der makroskopischen und der mikroskopischen Personenstromsimulation, vereint und die jeweiligen Nachteile kompensiert. Dies kann dadurch erreicht werden, dass in bestimmten Bereichen, deren Details für die konkrete Fragestellung irrelevant sind, makroskopisch simuliert wird, während relevante Bereiche mikroskopisch evaluiert werden.

Für die makroskopische Simulation wird zunächst ein Teilgebiet ausgewählt, das nur über bestimmte Schnittstellen wie z.B. Türen betreten werden und auch wieder nur über örtlich begrenzte Auslässe verlassen werden kann. Ein Beispiel dafür wäre die Empfangshalle in einem Hotel, die für den eingehenden Personenstrom von außen mit der Eingangstür, und für die ausgehenden Personenströme nach innen über Aufzüge, Gänge und Treppen verbunden ist. Dieses der Empfangshalle entsprechende Teilgebiet kann makroskopisch simuliert werden, während andere an die Ein- und Ausgänge angrenzende Teilgebiete mikroskopisch simuliert wird. Je nach Fragestellung kann auch umgekehrt vorgegangen werden, d.h. die Empfangshalle kann mikroskopisch simuliert werden, während die an die Ein- und Ausgänge angrenzenden Teilgebiete makroskopisch betrachtet werden.

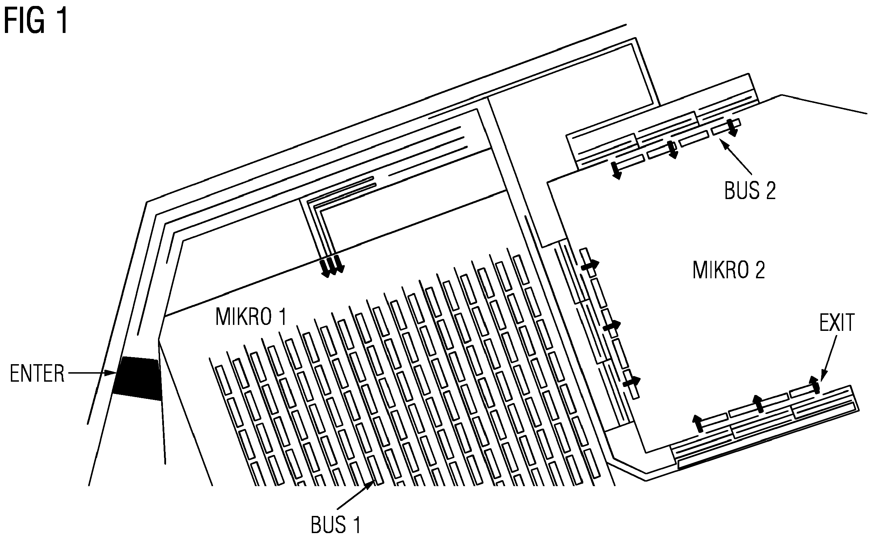

Figur 1 zeigt ein für eine Personenstromsimulation betrachtetes Gebiet. Das hier konkret dargestellte Beispiel ist ein Busbahnhof an einem Fußballstadion. Dieses Gebiet ist für eine Personenstromsimulation relevant, denn das Szenario am Ende eines Fußballspiels ist, dass eine große Anzahl von Personen das Stadion verlassen und versuchen, rasch zu den Bussen zu gelangen. Es soll also die Abfahrt der Personen nach dem Spiel bzw. deren Bewegung bis zu den Bussen simuliert werden. Mittels einer Echtzeitapplikation kann z.B. entschieden werden, wie viele Busse an welchen Haltestellen zur Verfügung gestellt werden müssen. Über die schwarze Eintrittsfläche ENTER erreichen die vom Stadion kommenden Personen die Warteschlangen im Busbahnhof. Insgesamt können die Teilbereiche, in welchen sich die Busse befinden, über zwölf mit Pfeilen markierte Zugänge EXIT erreicht werden. Zur Erhöhung der Übersichtlichkeit ist in Figur 1 nur einer der Zugänge EXIT beschriftet. Die Details in den Warteschlangen, also das Bewegungsverhalten der Personen zwischen der Eintrittsfläche ENTER und den Zugängen EXIT, sind für das Ziel der bedarfsgerechten Zur-Verfügung-Stellen von Bussen nicht relevant und können daher vereinfacht makroskopisch simuliert werden.

Für das Teilgebiet der makroskopischen Simulation liegt also ein eingehender Personenstrom über die Eintrittsfläche ENTER vor, und zwölf ausgehende Personenströme über die Zugänge EXIT. Die Eintrittsfläche ENTER ist die Schnittstelle für das Teilgebiet der makroskopischen Simulation für den Eingang von Personen, die Zugänge EXIT sind entsprechend die Schnittstellen für das Teilgebiet der makroskopischen Simulation für den Ausgang von Personen. Für die anderen beiden Teilgebiete MIKRO 1 und MIKRO 2 erfolgt eine mikroskopische Simulation. Da die Teilgebiete für die makroskopische und die mikroskopische Simulation aneinandergrenzen, entsprechen die Schnittstellen für das Teilgebiet der makroskopischen Simulation für den Ausgang von Personen den Schnittstellen für die Teilgebiete der mikroskopischen Simulation für den Eingang von Personen. Im ersten dieser Teilgebiete MIKRO 1 steht eine Vielzahl von Bussen BUS 1 zum Einsteigen bereit, wobei zur Erhöhung der Übersichtlichkeit nur einer der Busse beschriftet ist. Im zweiten dieser Teilgebiete MIKRO 2 stehen nur wenige on-demand Busse BUS 2 bereit, wobei neue Busse BUS 2 nach Bedarf bereitgestellt werden. Ebenfalls zur Erhöhung der Übersichtlichkeit ist nur einer der Busse BUS 2 beschriftet. Die beiden Teilgebiete MIKRO 1 und MIKRO 2 werden mikroskopisch simuliert, denn hier soll auf die konkrete Verteilung von Personen reagiert werden können. Z.B. soll das Anstehverhalten, die Bildung von Menschentrauben, Staus in der Nähe der Zugänge EXIT beobachtet werden, um gegebenenfalls durch Ordnungspersonal eingreifen zu können, sowie um bedarfsgerecht Busse zur Verfügung stellen zu können.

Die gesamte Personenstromsimulation ist somit eine Kombination aus einer makroskopischen Simulation, welche lediglich Personenflüsse berechnet, und einer mikroskopischen Simulation, welche als Ergebnis in den betroffenen Teilgebieten MIKRO 1 und MIKRO 2 über die Zeit anzeigt, an welchen Orten innerhalb dieser Teilgebiete sich zu den jeweiligen Zeitpunkten Personen befinden. Die Eingangsgröße für die makroskopische Simulation ist der Personenstrom über die Eintrittsfläche ENTER, das Ergebnis der makroskopischen Simulation sind die Personenströme über jede der zwölf Zugänge EXIT zu den Teilgebieten MIKRO 1 und MIKRO 2. Der Teilbereich zwischen der Eintrittsfläche ENTER und den zwölf Zugängen EXIT, welcher labyrinthähnliche Wege aufweist und daher mikroskopisch nur sehr zeitaufwendig zu simulieren wäre, kann als black box angesehen werden. Die Eingangsgrößen für die mikroskopische Simulation sind die Personenströme über die zwölf Zugänge EXIT, das Ergebnis der mikroskopischen Simulation ist eine Zeitserie von Personenverteilungen in den Teilgebieten MIKRO 1 und MIKRO 2. Dieses Ergebnis erlaubt die Verwendung der Personenstromsimulation in einer Echtzeitanwendung. Denn im Gegensatz zu dem für die makroskopische Simulation verwendeten Teilgebiet weisen die Teilgebiete MIKRO 1 und MIKRO 2 eine wenig komplizierte Topologie auf, so dass hier eine mikroskopische Personenstromsimulation in kurzer Zeit berechenbar ist.

Während die Vorgehensweise der mikroskopischen Simulation als bekannt vorausgesetzt wird, wird im Folgenden näher auf die Berechnung der makroskopischen Simulation eingegangen. Als makroskopische Simulation wird ein KI-Verfahren (KI: Künstliche Intelligenz, im englischen AI) eingesetzt, das die Eingangsdaten, also den Personenstrom über die Eintrittsfläche ENTER, auf die Ausgangsdaten, also die Personenströme über die zwölf Zugänge EXIT, abbildet.

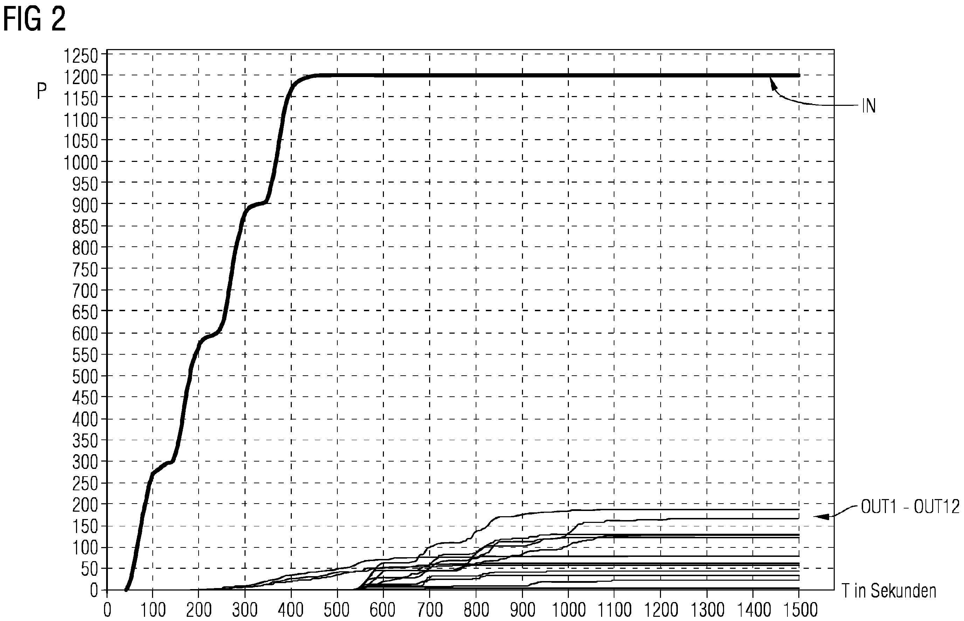

Vor Einsatz der KI für die makroskopische Simulation lernt diese unter Verwendung von Trainingsdaten. Ein Set von Trainingsdaten kann z.B. wie in Figur 2 dargestellt aussehen. Hierbei ist nach oben die akkumulierte Anzahl P von Personen aufgetragen, die den betrachteten Teilbereich über die Eintrittsfläche ENTER bis zum auf der Abszisse aufgetragenen Zeitpunkt T betreten haben. Hieraus ergibt sich der Inputverlauf IN. Hierzu gehören die zwölf OUTPUT Verläufe OUT1 - OUT12. Diese zwölf Verläufe geben die akkumulierte Anzahl P von Personen an, welche den jeweiligen Zugang EXIT bis zum auf der Abszisse aufgetragenen Zeitpunkt T überschritten haben.

Derartige Sets von Trainingsdaten können über Messungen erhalten werden. In diesem Fall liefern Sensoren zur Erfassung von Personen, welche sowohl die Eintrittsfläche ENTER, als auch die zwölf Zugänge EXIT beobachten, Messergebnisse, aus welchen der Inputverlauf IN und die OUTPUT Verläufe OUT1 - OUT12 ableitbar sind. Als Sensoren eigenen sich beispielsweise Kameras. Einfachere Technologien zur Erfassung von Personen sind z.B. Drehkreuze o.ä., oder ein Tripwire, welches das Überschreiten einer Linie durch Personen erkennt.

Alternativ zum Einsatz von Messungen kann zur Generierung der Trainingsdaten eine mikroskopische Simulation des Teilgebiets zwischen der Eintrittsfläche ENTER und den zwölf Zugänge EXIT verwendet werden. Denn für die Generierung von Trainingsdaten gibt es keine zeitliche Einschränkung, so dass ein großer Zeitaufwand zur Berechnung der Simulation nicht hinderlich ist. Es können hierbei virtuelle Tripwires in die Simulation eingefügt werden, so dass die mikroskopische Simulation die Personenströme über virtuelle Linien sowohl in der Eintrittsfläche ENTER als auch in den zwölf Zugängen EXIT berechnet.

Für die dem Beispiel der Figur 2 zugrundeliegende Simulation wurden jeweils 300 Personen zu den Zeitpunkten 0, 100 Sekunden, 200 Sekunden und 300 Sekunden am Rande der Eintrittsfläche ENTER generiert, welche mit einer kleinen Zeitverzögerung das virtuelle Tripwire innerhalb der Eintrittsfläche ENTER erreichen. Für diese Personen wird eine bestimmte Verteilung ihrer Bewegungsgeschwindigkeiten angenommen, insbesondere eine Gauß-Verteilung. Dementsprechend sieht man anhand des Inputverlaufs IN, wie diese Personen sich dann zeitversetzt über das virtuelle Tripwire bewegen. Dass die Personen mit unterschiedlichen Geschwindigkeiten generiert wurden, ist daran ersichtlich, dass die strenge Treppenstufenfunktion aus der Generierung im Inputverlauf IN bereits aufgeweicht ist.

An den zwölf OUTPUT Verläufen OUT1 - OUT12 sieht man, dass es sich nicht um eine einfache Verschiebung oder lineare Abbildung des Eingangssignals, also des Inputverlaufs IN, handelt. Vielmehr sehen die OUTPUT Verläufe OUT1 - OUT12 unterschiedlich voneinander aus, da sie durch die komplexen Vorgänge und die Topologie im Inneren des Teilgebiets bedingt sind. An manchen Ausgängen ist die Treppenfunktion des Eingangssignals noch erkennbar, während diese bei anderen Ausgängen stark verzerrt ist oder ganz durch einen stufenlosen Anstieg ersetzt ist. Dies macht klar, dass kein einfacher funktionaler Zusammenhang zwischen Eingang und Ausgang gefunden werden kann, z.B. über statistische Korrelation. Umgekehrt gilt aber auch, dass zwischen Eingang und Ausgang ein nicht-zufälliger Zusammenhang besteht, der durch Lernverfahren zumindest approximiert werden kann.

Der KI werden zum Zwecke des Lernens eine Vielzahl von Sets von Trainingsdaten zur Verfügung gestellt. Wenn diese Trainingsdaten durch eine Personenstromsimulation generiert werden, werden hierzu Parameter wie die Anzahl der Personen und ihre Geschwindigkeitsverteilung variiert, um ein breites Spektrum an verschiedenen Sets an Trainingsdaten zur Verfügung zu haben.

Für die konkrete Ausgestaltung der KI gibt es verschiedene Möglichkeiten. Trainieren lassen sich insbesondere künstliche neuronale Netze, rekurrente neuronale Netze, faltende neuronale Netze, Perzeptrone, bayessche neuronale Netze, Autoencoder, variationale Autoencoder, Gaußprozesse, Deep-Learning-Architekturen, Support-Vektor-Maschinen, datengetriebene Regressionsmodelle, k-nächste-Nachbarn-Klassifikatoren, physikalische Modelle und/oder Entscheidungsbäume. Als Trainingsmethode eignen sich insbesondere Methoden aus dem Bereich des Reinforcement Learnings, zum Beispiel Policy-Gradienten-Verfahren.

Obwohl durch Simulationsberechnungen an sich beliebig viele Sets von Trainingsdaten erzeugt werden könnten, ist in der Praxis dennoch die Anzahl der zur Verfügung stehenden Trainingsdaten üblicherweise begrenzt, insbesondere aufgrund der z.T. hohen Laufzeit der simulierten Szenarien. Daher ist ein Lernverfahren anzustreben, das mit möglichst wenigen Sets an Trainingsdaten auskommt:
Geeignet für das Lernen von beliebig langen Zeitreihen sind LSTM (Long Short-Term Memory) Netze - eine Spezialform rekurrenter neuronaler Netzwerke mit über Eingaben gesteuerten Speicherzellen. Damit wird das Problem von allgemeinen RNNs umgangen, dass Abhängigkeiten von vergleichsweise lange zurückliegenden Eingaben über die Zeit "verblassen", oder ihre Aufrechterhaltung unverhältnismäßig viele Trainingsdaten benötigen würde, um ein lange zurückliegendes Signal zu verstärken.

Eine noch vorteilhaftere Möglichkeit des Lernens unter Verwendung der erläuterten Trainingsdaten besteht darin, auf die Verarbeitung von Zeitreihen zu verzichten. Hierzu können herkömmliche neuronale Netze eingesetzt werden, so wie z.B. convolutional neural networks. Für das Mapping von Grafiken zueinander können nämlich einfachere neuronale Netze verwendet werden als für beliebige Zeitreihen.

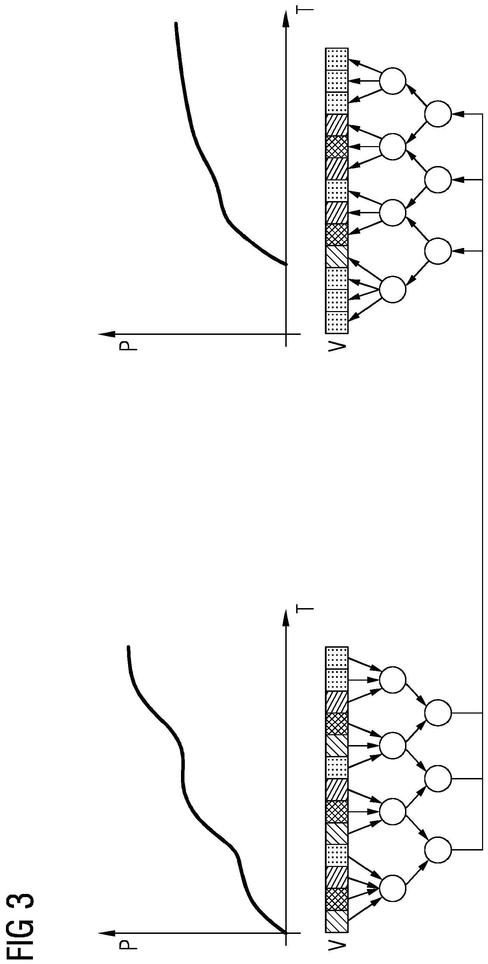

Hierbei kann man sich zu Nutze machen, dass die anhand von Figur 2 gezeigten Abhängigkeiten von Quelle und Ziel nur innerhalb eines begrenzten Zeitintervalls relevant sind. So ist in der Figur zu sehen, dass sich die akkumulierte Personenanzahl P ab ca. 1200 Sekunden nach dem Beginn in keiner der Kurven mehr verändert. Der Zeitraum vom Start (bei 0 Sekunden) bis zu diesem Zeitpunkt entspricht maximal der Zeit, welche die Person mit der langsamsten Bewegungsgeschwindigkeit vom Zeitpunkt ihrer Erzeugung in der Eintrittsfläche ENTER bis zum Erreichen des am entferntesten gelegenen der zwölf Zugänge EXIT benötigt. Die zur Berechnung dieser Zeitspanne benötigten Parameter sind bekannt, so dass diese Zeitspanne vorab berechnet werden kann. Den Verlauf der akkumulierten Personenzahl kann man innerhalb dieses bestimmten Zeitfensters als Grafik anstatt als Zeitreihe ansehen. Dies ist in Figur 3 illustriert, wo vereinfacht das Lernen eines neuronalen Netzes mit Trainingsdaten gemäß Figur 2 dargestellt ist. Der Verlauf P auf der linken Seite entspricht der akkumulierten Personenzahl in der Eintrittsfläche ENTER, der Verlauf P auf der rechten Seite entspricht der akkumulierten Personenzahl P von einem der zwölf Zugänge EXIT, wobei die Skalierung der beiden Ordinaten unterschiedlich ist. Zur Erhöhung der Übersichtlichkeit ist der Verlauf P nur von einem der zwölf Zugänge EXIT in der Figur 3 enthalten. Ein Set von Trainingsdaten enthält jedoch für jeden Verlauf P der akkumulierten Personenzahl in der Eintrittsfläche ENTER (linke Seite der Figur 3) zwölf Verläufe P für die zwölf Zugänge EXIT. Das Vorgehen entspricht dem herkömmlichen Bilderlernen: der Wert des Verlaufs P zu einem bestimmten Zeitpunkt T wird als ein Datenpunkt angesehen, wobei jeder der der KI zur Verfügung gestellte Vektor V eine Mehrzahl solcher Datenpunkte enthält. Insgesamt führt das Training über die Vektoren V im Gegensatz zu einem Training über Zeitreihen zu einem deutlich reduzierten Bedarf an Trainingsdaten. Wie in den Figuren 2 und 3 erkennbar ist, sind die Funktionen monoton steigend, was das Training ebenfalls vereinfacht.

Die KI eignet sich anhand der Trainingsdaten das Abbilden der akkumulierten Personenzahl in der Eintrittsfläche ENTER auf die akkumulierten Personenzahlen in den zwölf Zugängen EXIT an. Beim Berechnen einer Simulation werden der KI als Inputdaten gemessene Personenströme in der Eintrittsfläche ENTER vorgegeben. Hieraus ermittelt die KI dann zugehörige Personenströme an den zwölf Zugängen EXIT. Somit kann die trainierte KI nun als stellvertretendes Modell für ein detaillierteres Personensimulationsmodell in dem Teilgebiet zwischen der Eintrittsfläche ENTER und den zwölf Zugängen EXIT eingesetzt werden. Für die Echtzeitsimulation eines realen Szenarios werden am Eingang, also in der Eintrittsfläche ENTER, Tripwires oder andersartige Zähler installiert, welche den Trainingsdaten entsprechende Eingangsdaten für die KI liefern. Die Ergebnisse der KI, d.h. die prognostizierten Personenströme an den zwölf Zugängen EXIT, werden dann als Eingangsdaten für die mikroskopische Simulation der anderen Teilgebiete verwendet. Das Ergebnis dieser mikroskopischen Simulation steht daher deutlich schneller zur Verfügung, als wenn das gesamte Gebiet mikroskopisch simuliert werden müsste. Es kann also die Geschwindigkeit der Berechnung deutlich erhöht werden, während die Genauigkeit in den immer noch mikroskopisch berechneten Teilgebieten nicht leidet.

Ein Unterschied zu bekannten Verfahren der mikroskopischen Simulation ist daher die Ausblendung eines großen Teils des Simulationsgebiets unter Verwendung eines stellvertretenden Modells, welches eine makroskopische Simulation durchführt. Dabei wird der Personenstrom an einer oder mehreren geeigneten Schnittstellen zum von der mikroskopischen Simulation ausgenommen Teil gemessen und die sich daraus ergebenden Funktionen dienen als Eingabe für die makroskopische Simulation. Dieses stellvertretende Modell kann eine KI sein, insbesondere ein neuronales Netzwerk, wie oben beschrieben. Alternativ zu einer KI kann ein statistisches Verfahren zum Einsatz kommen, z.B. eine gewöhnliche mathematische Analyse wie z.B. mittels Fourier-Reihen. Dies ist umso leichter möglich, je weniger kompliziert der Zusammenhang zwischen Eingangs- und Ausgangsverläufen ist.

Das beschriebene Vorgehen kann für den Fall eingesetzt werden, dass die Ein-/Ausgänge zu dem makroskopisch simulierten Teilgebiet exklusiv benutzt werden, d.h. über eine bestimmte Schnittstelle können Personen das Teilgebiet nur ausschließlich betreten oder nur ausschließlich verlassen. Dies ist jedoch keine schädliche Einschränkung, denn viele einer Personenstromsimulation zugrundeliegende Szenarien beinhalten, dass Personen sich gezielt in eine Richtung bewegen, z.B. bei Evakuationen oder beim Verlassen großer Veranstaltungsstätten.

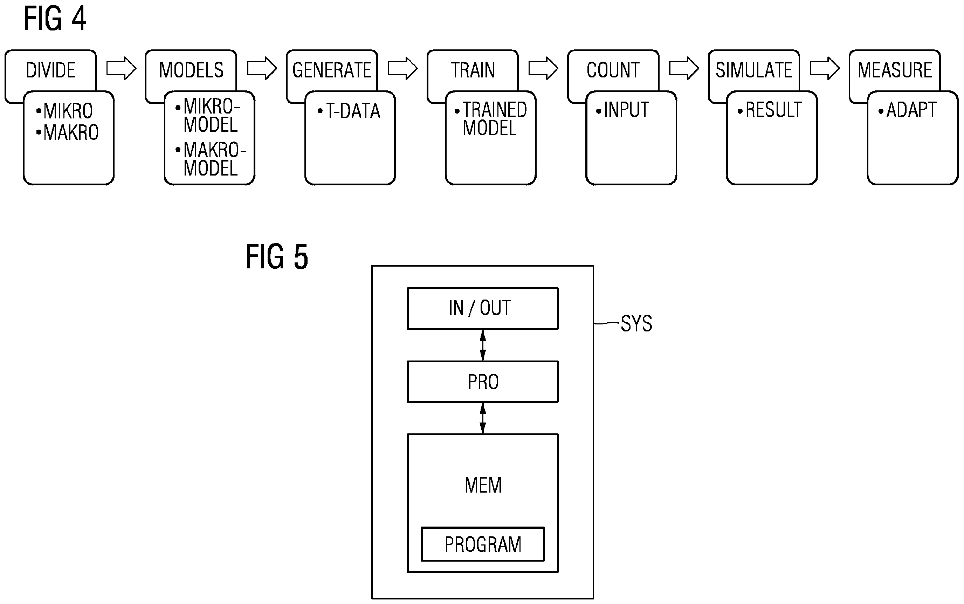

Zusammenfassend zeigt Figur 4 ein Ablaufdiagramm zu dem geschilderten Vorgehen. Zunächst wird das von der Personenstromsimulation zu betrachtende Gebiet im Schritt DIVIDE in zumindest zwei Teilgebiete MIKRO und MAKRO unterteilt, wobei für das Teilgebiet MIKRO eine mikroskopische Personenstromsimulation durchgeführt werden soll, und für das Teilgebiet MAKRO eine makroskopische Personenstromsimulation. Es kann eine Mehrzahl von Teilgebieten MIKRO und/der Teilgebieten MAKRO verwendet werden. Für die Teilgebiete MIKRO und MAKRO werden im Schritt MODEL Personenstromsimulationsmodelle MIKRO-MODEL für die mikroskopische Personenstromsimulation und MAKRO-MODEL für die makroskopische Personenstromsimulation erstellt. Für das Personenstromsimulationsmodell MAKRO-MODEL für die makroskopische Personenstromsimulation werden im Schritt GENERATE Trainingsdaten T-DATA erzeugt. Dies kann mittels Messungen oder mikroskopischer Simulation des Teilgebiets MAKRO erfolgen, alternativ kann auch auf bereits vorhandene Trainingsdaten T-DATA zugegriffen werden. Im Schritt TRAIN wird das Personenstromsimulationsmodell MAKRO-MODEL für die makroskopische Personenstromsimulation mit den Trainingsdaten T-DATA trainiert, wonach das trainierte Modell TRAINED MODEL zur Verfügung steht. Für eine Echtzeitanwendung werden im Schritt COUNT Personenanzahlen erfasst, welche als Eingangsdaten INPUT für die makroskopische Personenstromsimulation verwendet werden können. Im Schritt SIMULATE wird die Personenstromsimulation berechnet, wobei die makroskopische Personenstromsimulation von dem trainierten Modell TRAINED MODEL basierend auf den Eingangsdaten INPUT erfolgt, und die mikroskopische Personenstromsimulation basierend auf den Ergebnissen der makroskopischen Personenstromsimulation. Das Ergebnis RESULT der mikroskopischen Personenstromsimulation wird im folgenden Schritt MEASURE genutzt, um Maßnahmen ADAPT in der realen dem Teilgebiet MIKRO entsprechenden Umgebung umzusetzen.

Die beschriebene Vorgehensweise kann computergestützt ablaufen. Figur 5 zeigt, wie ein hierfür geeignetes System SYS aufgebaut sein kann. Während die im Folgenden näher erläuterten Bestandteile in der Figur einfach vorhanden sind, ist es auch möglich, dass diese in mehrfacher Ausführung vorhanden sind, z.B. als verteiltes System. Auf diese Weise kann die Funktionalität des Systems SYS auf mehrere, gegebenenfalls hierarchisch miteinander verknüpfte, Systeme aufgeteilt werden.

Das System SYS umfasst eine Recheneinheit bzw. einen Prozessor PRO. Dieser ist verbunden mit einem Speicher MEM, in welchem ein Computerprogramm PROGRAM abgelegt ist. Bei dem Speicher MEM handelt es sich vorzugsweise um ein nicht-flüchtiges computerlesbares Datenspeichermedium. Die Speicherung kann auf jegliche Weise erfolgen, welche geeignet ist, die Auslesbarkeit durch eine Recheneinheit zu gewährleisten, wie durch magnetische Speicherung, z.B. mittels Diskette, optische Speicherung, z.B. mittels CD, magneto-optische Speicherung, ROM (Read Only Memory) Speicherung, RAM (Random Access Memory) Speicherung, EPROM (Erasable Programmable Read-Only Memory), EEPROM (Electrically Erasable Programmable Read-Only Memory), Flash-Memory.

Durch Ausführen der Instruktionen des Programms PROGRAM in dem Prozessor PRO werden die Schritte der oben erläuterten Vorgehensweise durchgeführt. Dies betrifft insbesondere den Schritt SIMULATE, welcher die Berechnung des Simulationsergebnisses beinhaltet. Die anderen Schritte können von dem gleichen oder einem anderen Computersystem durchgeführt werden. Hierzu ist der Prozessor PRO mit einer Ein- und Ausgabeeinheit IN/OUT verbunden, über welche Informationen zwischen dem System SYS und anderen Komponenten und/oder einem Nutzer ausgetauscht werden können. Z.B. können hierüber dem Personenstromsimulationsmodell die gemessenen Personenanzahlen zur Verfügung gestellt und die das Simulationsergebnis ausgegeben werden. Diese Schnittstelle kann hierbei auf geeignete Weise ausgestaltet sein, z.B. über Funk oder über Kabel, und die Kommunikation kann über geeignete Standards erfolgen.

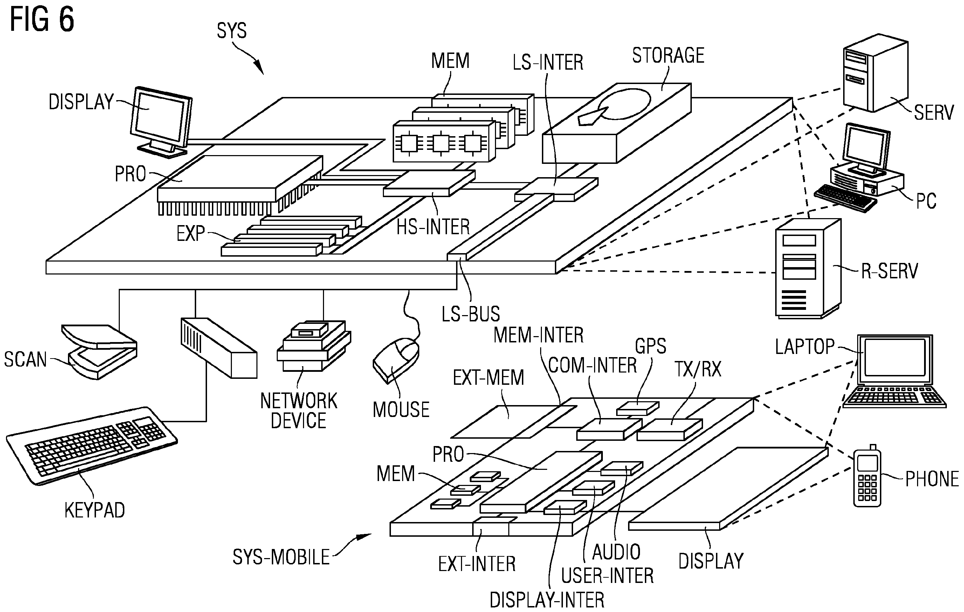

Figur 6 zeigt beispielhaft, wie das System der Figur 5 ausgestaltet sein kann: dies kann ein generischer Computer SYS oder ein mobiler generischer Computer SYS-MOBILE sein. Hierbei repräsentiert der generischer Computer SYS verschiedene Arten digitaler Computergeräte, so wie z.B. Desktopcomputer, Workstations, Server, Blade Server, Mainframes, oder andere geeignete Geräte. Der mobile generische Computer SYS-MOBILE steht entsprechend für verschiedene Arten mobiler digitaler Computergeräte, so wie z.B. Laptops, PDAs, Mobiltelefone oder Smart Phones, oder andere geeignete Geräte. Wenn anhand von Figur 6 konkret und detailliert verwendbare Komponenten aufgezeigt und erläutert werden, ist dies beispielhaft zu verstehen; die Realisierung der Erfindung ist nicht auf diese Komponenten beschränkt.

Der Computer SYS umfasst einen Prozessor PRO, einen Speicher MEM, und dazwischen ein Hochgeschwindigkeits-Interface HS-INTER. Ferner sind Hochgeschwindigkeits-Expansion Ports EXP und ein Low-speed-Interface LS-INTER an das Hochgeschwindigkeits-Interface HS-INTER angeschlossen. An das Low-speed-Interface LS-INTER sind das Speichergerät STORAGE und der Low-speed Bus LS-BUS angeschlossen. Die Komponenten PRO, MEM, STORAGE, HS-INTER, EXP, LS-INTER sind über geeignete Verbindungen/Busse verbunden, und können auf einem gemeinsamen Motherboard montiert sein.

Während in Figur 6 die Komponenten des Computers SYS in einfacher Ausführung dargestellt sind, ist es auch möglich, manche oder alle dieser Komponenten mehrfach vorzusehen. Auch kann der Computer SYS mehrere miteinander verbundene Computer umfassen, welche sich gegebenenfalls an verschiedenen Orten befinden.

Der Prozessor PRO kann Instruktionen verarbeiten, die im Computer SYS ausgeführt werden sollen, wobei die Instruktionen insbesondere im Speicher MEM oder im Speichergerät STORAGE gespeichert sein können. Informationen, insbesondere Ergebnisse der Verarbeitung im Prozessor PRO, können mittels einer GUI auf einer an das Hochgeschwindigkeits-Interface HS-INTER angeschlossene Anzeige wie dem Bildschirm DISPLAY grafisch ausgegeben werden.

Der Speicher MEM dient der Speicherung von Informationen innerhalb des Computers SYS. Hierbei kann es sich um einen flüchtigen Speicher oder einen nicht-flüchtigen Speicher handeln. Er kann mehrere Speicherzellen umfassen. Bei dem Speichergerät STORAGE handelt es sich vorzugsweise um ein Massenspeichergerät für ein computerlesbares Medium. Hierzu kann es z.B. ein Diskettenlaufwerk, eine Festplatte, ein Laufwerk für optische Speicherplatten, ein Bandgerät, ein Flash Memory-Speichergerät, oder auch eine Reihe von Geräten, z.B. in einer Storage Area Networks Konfiguration, umfassen.

Das Hochgeschwindigkeits-Interface HS-INTER ist zuständig für Bandbreiten-intensive Vorgänge innerhalb des Computers SYS, während das Low-speed-Interface LS-INTER für solche mit geringerem Bandbreitenbedarf verwendet wird. Hierzu ist das Hochgeschwindigkeits-Interface HS-INTER verbunden mit dem Speicher MEM, dem Bildschirm DISPLAY, gegebenenfalls über einen Grafikprozessor, den Hochgeschwindigkeits-Expansion Ports EXP, welche diverse Erweiterungskarten aufnehmen können. An das Low-speed-Interface LS-INTER angebunden sind das Speichergerät STORAGE und der Low-speed Bus LS-BUS, an welchem sich Low-Speed-Expansion Ports befinden können. Letztere können verschiedene Kommunikationsanschlüsse aufweisen, z.B. USB, Bluetooth, Ethernet, drahtloses Ethernet. An diese können diverse Ein- und/oder Ausgabevorrichtungen angeschlossen sein, z.B. eine Tastatur KEYPAD, eine Maus MOUSE, ein Scanner SCAN, ein Netzwerkgerät NETWORK DEVICE wie ein Switch oder ein Router. Diese Aufgabenverteilung zwischen den beiden Interfaces HS-INTER und LS-INTER ist beispielhaft und kann auch anders organisiert sein.

Der Computer SYS kann auf verschiedene Arten implementiert sein, wie am rechten Rand der Figur zu sehen ist. Z.B. kann er implementiert sein als ein Personal Computer PC, als ein Standard-Server SERV, oder auch als eine Gruppe solcher Sever wie z.B. eine Serverfarm, oder als ein Rack-Server-System R-SERV oder Bestanteil eines solchen Systems.

Der mobile Computer SYS-MOBILE umfasst einen Prozessor PRO, einen Speicher MEM, eine Ein- und Ausgabevorrichtung DISPLAY, ein Kommunikations-Interface COM-INTER, einen Transceiver TX/RX. Die Komponenten PRO, MEM, COM-INTER, TX/RX sind über geeignete Verbindungen/Busse verbunden, und können auf einem gemeinsamen Motherboard oder in anderer geeigneter Weise montiert sein. Ferner kann eine weitere Speichereinrichtung, wie z.B. ein Mikrodrive o.ä., vorgesehen sein, um weitere Speicherungsmöglichkeit zu schaffen.

Der Prozessor PRO kann Instruktionen innerhalb des mobilen Computers SYS-MOBILE ausführen, insbesondere solche, die im Speicher MEM abgelegt sind. Er kann als Chip oder Chipset implementiert sein, welcher eine oder mehrere analoge oder digitale Prozesseinheiten enthält. Zuständig kann der Prozessor PRO u.a. sein für die Koordination der anderen Komponenten des mobilen Computers SYS-MOBILE, so z.B. für die Steuerung der Benutzerschnittstelle(n), für Applikationen, welche auf dem mobilen Computers SYS-MOBILE laufen, und für die drahtlose Kommunikation des mobilen Computers SYS-MOBILE. Zwischen dem Nutzer des mobilen Computers SYS-MOBILE und dem Prozessor PRO findet eine Informationsübertragung statt über das Nutzer-Interface USER-INTER, beispielsweise über Sprach-Ein/Ausgabe, sowie über das Display-Interface DISPLAY-INTER, beispielsweise über Text- Ein/Ausgabe. Die Ein- und Ausgabevorrichtung DISPLAY kann z.B. auf der TFT LCD (Thin-Film-Transistor Liquid Crystal Display) oder der OLED (Organic Light Emitting Diode) Technologie basieren.

Ferner ist ein an den Prozessor PRO angebundenes externes Interface EXT-INT vorgesehen, über welches eine Nahfeldkommunikation des mobilen Computers SYS-MOBILE mit anderen Geräten möglich ist. Über das externe Interface EXT-INT kann drahtgebunden und/oder über Funk kommuniziert werden.

Der Speicher MEM dient der Speicherung von Informationen innerhalb des mobilen Computers SYS-MOBILE und kann hierzu z.B. als flüchtiger oder nicht-flüchtiger Speicher umfassend eine oder mehrere Speichereinheiten implementiert sein. Zusätzlich kann ein Erweiterungsspeicher EXT-MEM vorgesehen sein, welches mit dem mobilen Computer SYS-MOBILE über das Erweiterungs-Interface MEM-INTER verbunden ist, z.B. eine Schnittstelle für ein SIMM (Single In Line Memory Module) oder ein SIM (Subscriber Identity Module). Der Erweiterungsspeicher EXT-MEM bietet zusätzliche Speicherkapazität für den mobilen Computer SYS-MOBILE und kann auch diverse Applikationen speichern. Z.B. kann der Erweiterungsspeicher EXT-MEM als Sicherheitsmodul für den mobilen Computer SYS-MOBILE dienen, indem Identifikationsinformationen dort abgelegt werden.

Der mobile Computer SYS-MOBILE kann drahtlos über den Transceiver TX/RX kommunizieren, welcher hierzu über Mittel zur digitalen Signalverarbeitung verfügt. Das Kommunikations-Interface COM-INTER ermöglicht die Kommunikation über geeignete Protokolle, wie z.B. GSM, SMS, MMS, CDMA, TDMA, PDC, WCDMA, CDMA2000, GPRS, EDGE, UMTS, LTE, sowie Kommunikationsprotokolle der 5ten oder höherer Generationen. Zusätzlich zum hierfür verwendeten Transceiver TX/RX kann ein nicht dargestellter Transceiver für Nahfeldkommunikation wie z.B. Bluetooth, WiFi o.ä. vorgesehen sein. Schließlich kann auch ein GPS-Modul GPS vorgesehen sein, um ortsbezogene Dienste verwenden zu können. Mittels des Audio-Codec AUDIO können empfangene Audioinformationen, welche insbesondere Instruktionen eines Nutzers umfassen können, in vom mobilen Computer SYS-MOBILE verarbeitbare digitale Informationen umgewandelt werden; entsprechend können unter Verwendung des Audio-Codec AUDIO vom Nutzer erfassbare Klanginformationen generiert werden.

Wie auf der rechten Seite der Figur zu sehen, ist der mobile Computer SYS-MOBILE vorzugsweise als Smartphone PHONE oder Laptop LAPTOP implementiert.

Die Interaktion zwischen dem Nutzer und dem Computer SYS oder dem mobilen Computer SYS-MOBILE kann auf verschiedenste Weise erfolgen und ist nicht auf die konkrete Darstellung der Figur 6 beschränkt. Jegliche sensorische Informationsübermittlung (sichtbar, hörbar, taktil wahrnehmbar) ist möglich.

Während die Komponenten des Computers SYS und des mobilen Computers SYS-MOBILE getrennt beschrieben wurden, ist es auch möglich, einen Computer einzusetzen, welcher sowohl Komponenten des Computers SYS, als auch des mobilen Computers SYS-MOBILE umfasst.

Das in Figur 5 gezeigte Computerprogramm PROGRAM kann in jedem der Speicher MEM, STORAGE, EXT-MEM der Figur 6 abgelegt sein, auch verteilt auf mehrere Speicher. Ferner kann eine Speicherung alternativ oder zusätzlich auch Cloud-basiert erfolgen.

Die Erfindung wurde voranstehend an einem Ausführungsbeispiel beschrieben. Es versteht sich, dass zahlreiche Änderungen und Modifikationen möglich sind, ohne dass der Rahmen der Erfindung verlassen wird.

## Patentansprüche

1. Verfahren zur Simulation von Personenströmen in einem mehrere Teilgebiete umfassenden Gebiet, bei dem für ein erstes Teilgebiet eine makroskopische Personenstromsimulation berechnet wird,
bei welcher als Eingangsdaten (IN) zumindest eine Personenanzahl (P) an zumindest einer Eingangsschnittstelle (ENTER) des ersten Teilgebiets verwendet wird, und als Ergebnis (OUT1-OUT12) zumindest eine Personenanzahl (P) an zumindest einer Ausgangsschnittstelle (EXIT) des ersten Teilgebiets berechnet wird,
für ein zweites Teilgebiet (MIKRO 1, MIKRO 2) eine mikroskopische Personenstromsimulation berechnet wird,
bei welcher als Eingangsdaten die zumindest eine berechnete Personenanzahl (P) an der zumindest einen Ausgangsschnittstelle (EXIT) des ersten Teilgebiets verwendet wird, und als Ergebnis eine Verteilung von Personen innerhalb des zweiten Teilgebietes (MIKRO 1, MIKRO 2) für mehrere Zeitpunkte berechnet wird.

2. Verfahren nach Anspruch 1, bei dem
die zumindest eine Personenanzahl (P) an der zumindest einen Eingangsschnittstelle (ENTER) und der zumindest einen Ausgangsschnittstelle (EXIT) eine Zeitreihe von Personenflüssen oder von akkumulierten Personenanzahlen ist.

3. Verfahren nach Anspruch 1 oder 2, bei dem die makroskopische Personenstromsimulation unter Verwendung einer künstlichen Intelligenz berechnet wird.

4. Verfahren nach Anspruch 3, bei dem
die künstliche Intelligenz vor Berechnung der makroskopische Personenstromsimulation unter Verwendung von Trainingsdaten trainiert wird, wobei
die Trainingsdaten zumindest eine Personenanzahl (P) an der zumindest einen Eingangsschnittstelle (ENTER) des ersten Teilgebiets und zumindest eine Personenanzahl (P) an der zumindest einen Ausgangsschnittstelle (EXIT) des ersten Teilgebiets umfassen.

5. Verfahren nach Anspruch 4, bei dem
die Trainingsdaten mittels einer mikroskopischen Personenstromsimulation des ersten Teilgebiets generiert werden.

6. Verfahren nach Anspruch 5, bei dem
zur Generierung der Trainingsdaten eine Vielzahl von mikroskopischen Personenstromsimulation des ersten Teilgebiets mit verschiedenen Personenanzahlen an der zumindest einen Eingangsschnittstelle (ENTER) des ersten Teilgebiets berechnet werden.

7. Verfahren nach Anspruch 4, bei dem
die Trainingsdaten mittels Messungen von Personenanzahlen (P) im ersten Teilgebiet ermittelt werden.

8. Verfahren nach einem der Ansprüche 1 bis 7, bei dem
die Eingangsdaten (IN) für die makroskopische Personenstromsimulation des ersten Teilgebiets mittels Messungen von Personenanzahlen (P) im ersten Teilgebiet ermittelt werden.

9. Verfahren nach einem der Ansprüche 3 bis 8, bei dem es sich bei der künstlichen Intelligenz um ein LSTM-Netz handelt, welchem zur Berechnung der makroskopische Personenstromsimulation die Eingangsdaten (IN) als Zeitverlauf variabler Länge zur Verfügung gestellt werden.

10. Verfahren nach einem der Ansprüche 3 bis 8, bei dem es sich bei der künstlichen Intelligenz um ein neuronales Netz handelt, welchem zur Berechnung der makroskopische Personenstromsimulation die Eingangsdaten (IN) als Vektor konstanter Länge zur Verfügung gestellt werden.

11. Verfahren nach einem der Ansprüche 1 bis 10, bei dem unter Verwendung des Ergebnisses der mikroskopischen Personenstromsimulation eine einen realen Personenstrom verändernde Maßnahme im zweiten Teilgebiet (MIKRO 1, MIKRO 2) durchgeführt wird.

12. Vorrichtung oder System zur Datenverarbeitung (SYS), umfassend Mittel zur Ausführung des Verfahrens nach einem der Ansprüche 1 bis 11.

13. Computerprogramm (PROGRAM), umfassend Befehle, die bei der Ausführung des Programms durch einen Computer diesen veranlassen, die Schritte des Verfahrens nach einem der Ansprüche 1 bis 11 auszuführen.

14. Computerlesbares Speichermedium (MEM) mit einem Computerprogramm (PROGRAM) nach Anspruch 13.

15. Übertragungssignal, das das Computerprogramm (PROGRAM) nach Anspruch 13 überträgt.
